# FASCICULE DE BREVET EUROPEEN

(11) **EP 4 296 694 B1**
(45) Date de publication et mention de la délivrance du brevet: **11.03.2026**
(21) Numéro de dépôt: 23178078.4
(22) Date de dépôt: 07.06.2023
(51) Int. Cl.: G01R 15/18, G01R 1/18, G01R 1/22, G01R 15/20, G01R 31/52

(54) **PINCE DE MESURE POUR COURANTS DE FUITE AC ET DC**
MESSZANGE FÜR AC- UND DC-LECKSTRÖME
MEASURING CLAMP FOR AC AND DC LEAKAGE CURRENTS

(30) Priorité: 23.06.2022 FR 2206239
(43) Date de publication de la demande: 27.12.2023
(73) Titulaire: Chauvin Arnoux, 92600 Asnieres-sur-Seine (FR)
(72) Inventeur: PILLIAS, Benoît, ASNIERES-SUR-SEINE (FR); DUDOGNON, Stéphane, ASNIERES-SUR-SEINE (FR); PION, Francisque, ASNIERES-SUR-SEINE (FR)
(74) Mandataire: Cabinet Beau de Loménie

(56) Documents cités:
- WO-A1-2010/106304
- CN-A- 108 226 610
- CN-U- 211 505 675
- CN-U- 212 433 241
- JP-A- 2006 046 922
- US-A- 5 825 175
- US-A1- 2001 050 552
- US-A1- 2009 058 399
- US-A1- 2014 009 146
- US-A1- 2016 018 455

## Description

### Domaine Technique

La présente invention se rapporte au domaine de la mesure des courants alternatifs et/ou continus et elle concerne plus particulièrement une pince de mesure pour courants de fuite capable de mesurer des courants AC et DC de faible valeur (<1mA) et de manière fiable (erreur inférieure à 10% à 1mA).

### Technique antérieure

Le courant de fuite est la somme vectorielle des courants circulant dans les fils enserrés simultanément dans la pince de mesure. Cette somme est très faible par rapport aux courants directs qui circulent dans chacun de ces fils. Aussi, pour assurer une mesure fiable, il est nécessaire que les influences liées aux champs magnétiques extérieurs (champ terrestre, courant extérieur adjacent à la pince...) et au mode différentiel (phase et neutre passant en même temps dans la pince) soit faibles comparé au courant à mesurer.

Dans la plupart des pinces de mesure de courants AC et DC, un capteur magnétique est utilisé pour mesurer la partie DC du signal, la partie AC étant mesurée par une bobine entourant symétriquement le circuit magnétique et qui réalise également l'annulation de flux en DC pour éviter la saturation du circuit magnétique lorsqu'un courant important circule dans le circuit magnétique. La fréquence de « recoupe » entre les deux systèmes de mesure (capteur magnétique et bobine d'annulation de flux), c'est-à-dire la fréquence au-delà de laquelle le signal issu de la bobine d'annulation de flux domine par son amplitude le signal du capteur de champ magnétique, est typiquement de l'ordre de quelques Hertz à quelques dizaines de Hertz.

Certains modèles de pince de mesure donnent d'excellents résultats en rejection des champs magnétiques extérieurs (typiquement supérieur à 100dB). Cependant, ces modèles ne fonctionnent qu'en courant alternatif et l'ajout d'une fonctionnalité de mesure en courant continu nécessite, dans le circuit magnétique, l'emploi particulièrement complexe d'un ou plusieurs capteurs magnétiques dont l'équilibrage vis-à-vis de ces champs magnétiques extérieurs doit être fait en usine, par exemple avec une bobine de Helmholtz. Quant aux modèles ne fonctionnant qu'en courant continu, dont les capteurs employés sont souvent à effet Hall, ils s'avèrent trop bruyants et ne peuvent pas mesurer de très faibles courants de fuite (de l'ordre de 100µA), c'est-à-dire avec au moins 100dB d'atténuation entre un courant adjacent à la pince et un courant passant dans la pince, ce qui correspond à mesurer un courant de 100µA en présence d'un conducteur adjacent à la pince passant 10A, et avec au moins 100dB d'atténuation en mode différentiel, ce qui correspond à ne pas mesurer plus de 100µA de courant de fuite lorsqu'un conducteur traversé par un courant de 10A passe dans les deux sens de la pince.

Pour obtenir plus de précision, il est connu aussi de recourir à des technologies de capteurs moins bruyantes que les capteurs à effet Hall, comme les capteurs de type porte de flux (fluxgate). Toutefois, ces capteurs qui font au moins 5mm de long ne peuvent être intégrés dans les entrefers du circuit magnétique et doivent être disposés dans le corps même de la pince de mesure, ce qui une fois encore ne permet pas d'atteindre des niveaux de réjection précités.

Le document WO 2010/106304 divulgue un capteur de courant à deux bras pour mesurer le courant circulant dans un câble. Les bras sont formés d'un matériau laminé de perméabilité élevée et comprennent à une extrémité un capteur magnétique blindé magnétiquement par une manchette placée autour de l'entrefer formé entre les deux extrémités opposées des deux bras.

Le document US 2014/009146 divulgue un transducteur de courant en forme de U ou O permettant de mesurer un courant circulant dans un câble.

Le document US 2001/050552 divulgue un capteur de courant magnéto-résistif.

Le document CN 212 433 241 divulgue un capteur de courant comprenant deux cœurs magnétiques opposés et formant un tore entourant le conducteur dont on mesure le courant de circulation.

Le document CN 211 505 675 divulgue un capteur de courant à boucle fermée à faible puissance.

Le document CN 108 226 610 divulgue un capteur de courant sous forme de pince pour mesurer des courants alternatifs ou continus de faible amplitude.

### Exposé de l'invention

La présente invention a donc pour but principal une pince de mesure de courant de fuite AC et DC qui permet une très forte réjection des champs magnétiques extérieurs. Un autre but de l'invention est de permettre à un opérateur d'effectuer seul l'équilibrage de capteurs magnétiques de la pince de mesure sans avoir à retourner cette dernière à l'usine. Ces buts sont atteints par la pince de mesure selon la revendication 1 et par l'utilisation d'une telle pince selon la revendication 10.

Ainsi, en sortant la bobine d'annulation de flux du blindage magnétique, elle peut alors être séparée en deux demi-bobines générant deux champs magnétiques en opposition pour permettre un équilibrage des capteurs à flux magnétique en cas de champ magnétique extérieur parasite.

De préférence, chacune des mâchoires fixe et mobile est formée d'un demi-tore de mesure assurant la concentration du champ magnétique interne entouré par un demi-blindage en matériau magnétique protégeant des champs magnétiques extérieurs, de préférence en Mu-métal.

Avantageusement, le demi-tore de mesure de la mâchoire fixe comporte à chaque extrémité une fenêtre pour les amenées de courant depuis une carte électronique reliée par un câble de connexion à une interface utilisateur de la pince de mesure. De préférence, la bobine externe d'annulation de flux est constituée de deux bobinages, placés autour d'un seul des deux demi-blindages magnétiques, de préférence le demi-blindage de la mâchoire mobile, et aptes à générer au niveau des deux capteurs à flux magnétique deux champs magnétiques en opposition dans un repère tournant ou bien de deux bobinages placés autour des deux demi-blindages magnétiques et aptes à générer au niveau des deux capteurs à flux magnétiques deux champs magnétiques en opposition dans un repère tournant.

Selon un mode de réalisation avantageux dans lequel le capteur à flux magnétique est un capteur AMR, la pince de mesure comprend en outre une bobine de test disposée sous chacun des capteurs AMR pour générer un champ magnétique de valeur connue au niveau du capteur AMR et un circuit de test associé pour déterminer l'état de saturation des capteurs AMR.

De préférence, le capteur AMR se compose de quatre résistances ferromagnétiques à couche mince reliées à un pont de Wheatstone, une bobine de flip et un circuit de commande associé permettant d'inverser la polarité de la tension de sortie du pont en appliquant des impulsions de courant de réglage (set) et de réinitialisation (reset) à la bobine de flip.

Avantageusement, les impulsions de set/reset sont pilotées à une fréquence de quelques kHz avec une durée de quelques centaines de nano secondes à quelques micros secondes.

De préférence, les entrefers ont une largeur inférieure à 1mm et supérieure à la largeur du capteur à flux magnétique.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif et sur les lesquels :
[Fig. 1] la figure 1 montre la structure interne d'une pince de mesure mâchoires ouvertes conforme à l'invention,
[Fig. 2] la figure 2 illustre les différents ensembles formant les deux mâchoires de la pince de mesure de la figure 1,
[Fig. 3] la figure 3 montre un détail d'une extrémité de la mâchoire portant le capteur magnétique,
[Fig. 4] la figure 4 montre le positionnement des bobines de test permettant de connaitre l'état de saturation des capteurs magnétiques,
[Fig. 5] la figure 5 illustre le circuit de mesure associé aux capteurs magnétiques de la pince de mesure, et
[Fig. 6] la figure 6 illustre le circuit de mesure associé aux bobines de test.

### Description des modes de réalisation

Le principe de l'invention repose sur l'utilisation d'un capteur à flux magnétique de type AMR (pour Anisotropic Magneto-Resistive) comme capteur de champ magnétique auquel sont adjoints des bobinages d'annulation de flux et une bobine de test de saturation du capteur.

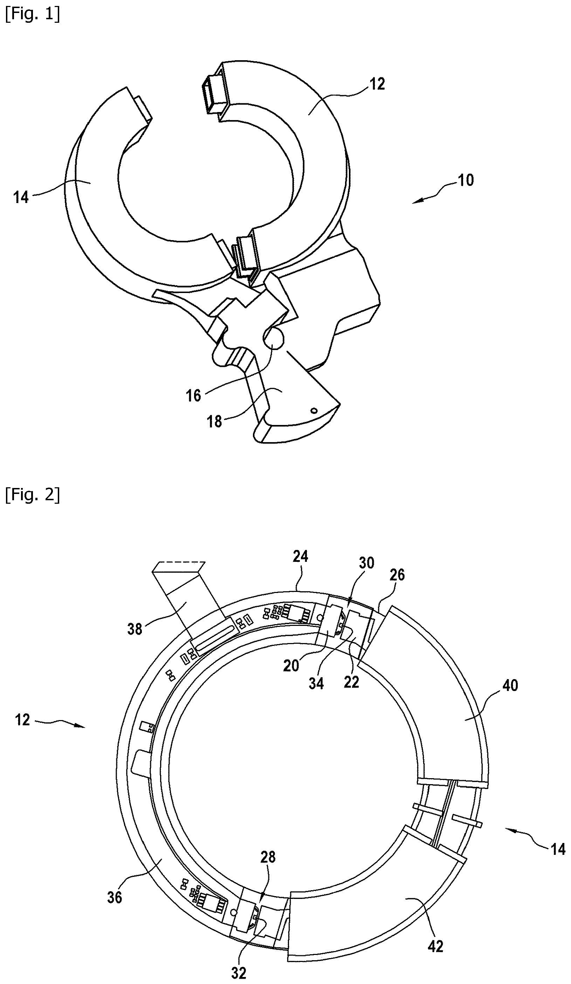

La structure interne de la pince de mesure, mâchoires ouvertes, de la figure 1 est destinée à mesurer des courants AC et DC, plus particulièrement des courants de fuite. Elle est illustrée dépourvue de son boitier externe avec son interface utilisateur comportant ses boutons de commande et son écran de visualisation disposés classiquement au niveau de sa poignée de maintien. La pince 10 est classiquement constituée d'une mâchoire fixe 12 et d'une mâchoire mobile 14 pouvant se désolidariser de la mâchoire fixe par pivotement autour d'un axe d'articulation 16 solidaire du corps de la poignée 18 et ainsi permettre l'insertion du conducteur (dénommé conducteur intérieur dans la suite de la description) ou des conducteurs enserrés dans les mâchoires de cette pince et dont on souhaite mesurer le courant.

Sur la figure 2, on peut observer que les deux mâchoires fixe 12 et mobile 14 sont constituées chacune d'un sous-ensemble constitué d'un demi-tore de mesure 20, 22 qui assure la concentration du champ magnétique, entièrement entouré par un demi-blindage en matériau magnétique 24, 26, de préférence en Mu-métal, qui s'emboîtent l'un sur l'autre à leurs deux extrémités pour assurer une protection des champs magnétiques extérieurs (cet emboitement n'est toutefois pas forcé mais glissant générant un très faible espace libre entre les deux demi-blindages pour permettre la rotation de la mâchoire mobile). Au niveau des deux jonctions diamétralement opposées 28, 30 entre les deux demi-tores 20, 22, dénommées « entrefers », sont disposés deux capteurs magnétiques 32, 34 soudés sur une même carte électronique 36 solidaire du seul demi-tore fixe 20 et recevant un câble de connexion 38 pour assurer la liaison avec l'interface utilisateur de la pince de mesure.

Il est important de noter que le blindage magnétique se présente sur l'intégralité du pourtour du tore de mesure et pas seulement au niveau des seuls entrefers, comme cela peut exister dans l'art antérieur. Un tel blindage enveloppant présente en effet une efficacité environ dix fois supérieure à un simple blindage d'extrémité auquel il ne peut donc être comparé. On rappellera que pour être efficace un blindage magnétique doit être séparé du tore de mesure par une lame d'air significative et avoir un entrefer le plus faible possible afin de faciliter au maximum le passage du champ magnétique parasite dans le blindage.

Pour éviter la saturation du circuit magnétique, deux bobinages externes d'annulation de flux 40, 42 indépendants l'un de l'autre sont placés autour d'un seul des deux demi-blindages, de préférence le demi-blindage 26 de la mâchoire mobile 14 (il reste cependant possible de mettre un bobinage sur chaque demi-tore fixe ou mobile). Cette configuration non symétrique et à l'extérieur des demi-blindages ne contribue pas à la mesure mais uniquement à l'annulation de flux et permet d'annuler aussi le flux magnétique dans ces demi-blindages qui restent donc toujours performants même lorsqu'un courant important circule dans les demi-tores 20, 22. La classique bobine d'annulation de flux n'a plus besoin d'être symétrique pour compenser les champs extérieurs parasites et peut donc être placée sur un seul demi-tore comme proposé. En outre, la réalisation de la bobine d'annulation de flux sous forme de deux bobinages (deux demi-bobines) permet de générer dans un repère tournant deux champs magnétiques en opposition au niveau des deux capteurs à flux magnétique, afin de régler les capteurs magnétiques en présence d'un champ magnétique parasite extérieur, sans recourir à la technique antérieure, comme il sera explicité plus avant.

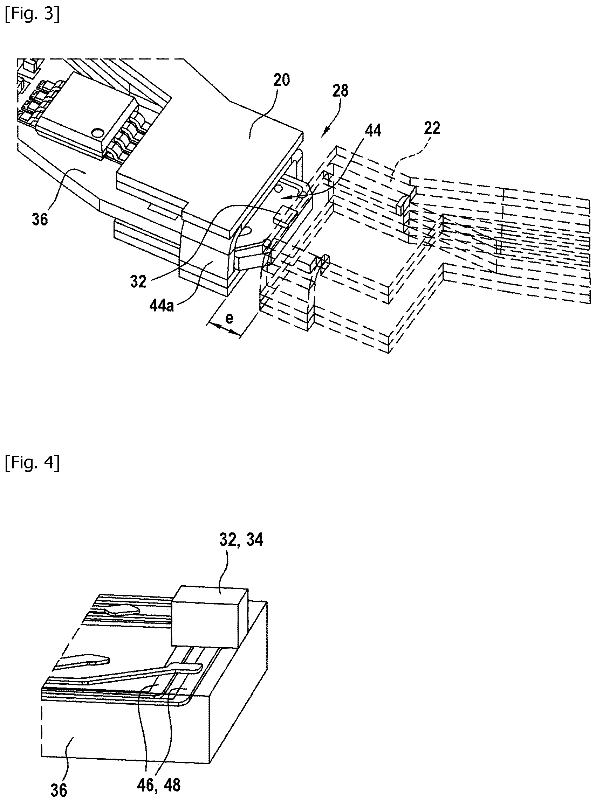

La figure 3 montre plus en détail la jonction au niveau des entrefers 28, 30 dans laquelle, pour mesurer les courants continus, est inséré le capteur magnétique 32, 34. Avec l'utilisation de la technologie AMR, le capteur doit se placer parallèlement aux lignes de champs et être parfaitement centré au milieu de l'entrefer dont la largeur e est supérieure à celle du capteur qui est typiquement de l'ordre ou inférieure à 1mm (par exemple 0,7mm). La faible valeur de l'entrefer permet en outre de limiter au maximum la pénétration des champs parasites extérieurs. Toutefois, ces champs parasites ayant réussi à passer au travers des espaces s'étendant entre les extrémités des demi-blindages 24, 26 resteraient malgré tout trop importants et pourraient fausser de manière notable la mesure si un seul capteur magnétique était utilisé pour cette mesure. C'est pourquoi l'invention utilise deux capteurs magnétiques, un au niveau de chaque entrefer, et s'affranchit de ces champs parasites extérieurs en faisant une addition des mesures de ces deux capteurs. En effet, le champ tournant généré dans les deux demi-tores de mesure par un conducteur intérieur s'additionne, alors que le champ généré par un conducteur extérieur circulant dans le même sens dans les deux capteurs se soustrait.

Lorsque les capteurs magnétiques présentent une largeur supérieure aux entrefers, les deux extrémités du demi-tore de mesure 20 de la mâchoire fixe 12 comporte une fenêtre 44 afin de libérer de l'espace pour la mise en place du capteur magnétique. Pour les capteurs magnétiques de largeur inférieure à l'entrefer, cette fenêtre facilite les amenées de courant via la carte électronique 36. Fonctionnellement, seules les parties haute et basse de cette fenêtre sont utiles pour générer le champ magnétique pour le capteur magnétique mais les deux côtés 44a de cette fenêtre ont un effet blindant pour se prémunir du champ rayonné au travers des espaces s'étendant entre les deux demi-blindages.

La partie sensible au champ magnétique du capteur AMR se compose de quatre résistances ferromagnétiques à couche mince reliées à un pont de Wheatstone. En plus du circuit de pont, le capteur AMR comprend d'autres composants tels qu'une bobine de flip externe et un circuit associé qui permet d'inverser de manière périodique la polarité de la tension de sortie du pont en appliquant des impulsions de courant de réglage (set) et de réinitialisation (reset) à la bobine de flip. En effet, ces capteurs AMR ont un offset qui varie en fonction de la température et du temps de manière non négligeable. Le circuit de set/reset (dit aussi de flip) positionné au plus proche du composant a pour effet d'inverser de manière périodique la polarité du capteur et de faciliter une annulation de cet offset lors du traitement du signal de mesure, comme il sera indiqué ci-après.

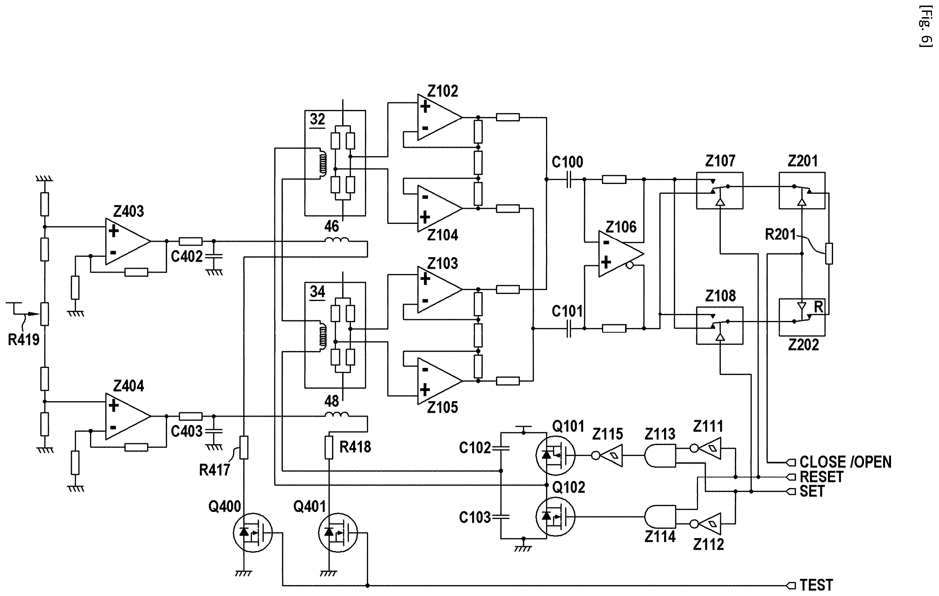

Ces capteurs AMR ont aussi des champs de saturation très bas (<1mT) et peuvent donc être rapidement saturé (par exemple en cas de changement de gamme de mesure ou lorsque la mesure est démarrée en présence d'un courant). Il est donc nécessaire de connaitre l'état de saturation du capteur magnétique pour éviter toute erreur dans la mesure. Or, lorsqu'un capteur AMR sature, en présence de variation du champ magnétique, la variation de tension en sortie est inversée ou nulle. Aussi, selon l'invention, et comme le montre la figure 4, des fils 46, 48 (ou une bobine de quelques tours (typiquement deux tours)) alimentés depuis un générateur de courant (illustré plus avant à la figure 6) sont disposés sous le capteur afin de générer un champ magnétique de valeur connue au niveau du capteur et de déterminer la saturation du capteur si sa tension de sortie ne bouge pas ou évolue dans le mauvais sens.

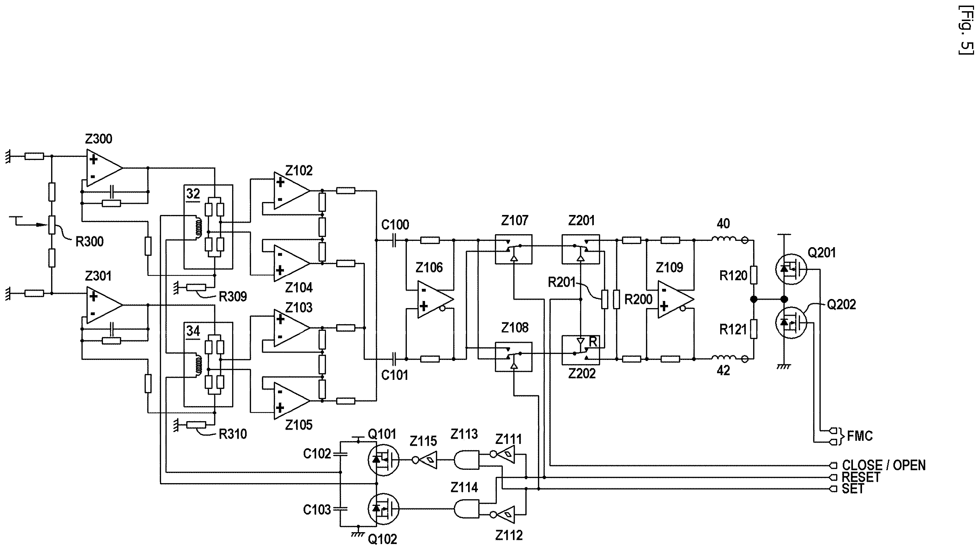

Le principe de la chaine d'acquisition des mesures est illustré à la figure 5. On notera que cette chaine d'acquisition peut être réalisée entièrement avec des amplificateurs « full différentiel » comme avec de simples amplificateurs différentiels standards (single-ended).

Elle est organisée autour de plusieurs fonctions. La première réalisée par les composants logiques Z111 à Z115 ainsi que les interrupteurs Q101, Q102 et les condensateurs C102 et C103 permet de piloter les bobines de flip des capteurs magnétiques de sorte que la sortie de ces capteurs se retrouve modulée à la fréquence de flip. Les commandes de set/reset sont pilotées à une fréquence de quelques kHz avec une durée de quelques centaines de nano secondes à quelques micros secondes.

La deuxième réalisée par les amplificateurs Z102 à Z105 permet d'amplifier le signal des capteurs magnétiques AMR 32,34. Ces amplificateurs doivent être positionnés au plus proche des capteurs pour limiter la pollution du signal par le bruit électromagnétique environnant. Les deux signaux issus de ces premiers amplificateurs sont dirigés ensuite vers un amplificateur différentiel Z106 ayant une double fonction : il permet d'une part de faire la soustraction de ces signaux et ainsi éliminer la partie du signal provenant des champs magnétique extérieurs et, d'autre part, avec les condensateurs C100 et C101 de supprimer la composante continue du signal modulé des capteurs magnétiques qui est l'offset que l'on souhaite annuler.

Le signal peut ensuite être démodulé par les commutateurs Z107 et Z108 dont la sortie donne l'image du champ magnétique différentiel, ou « tournant », dans le circuit magnétique. Les commutateurs Z201 et Z202 étant en position fermée, ce signal amplifié par un amplificateur différentiel Z109 est alors transmis aux bobinages externes d'annulation de flux 40, 42 afin d'annuler (ou plutôt réduire car un flux minimum est nécessaire à son fonctionnement) l'induction dans les capteurs. Le nombre de spires de la bobine étant que quelques centaines de tours, Le courant fournis par l'amplificateur n'est que de quelques milliampères. L'image du courant de mesure est la somme des tensions aux bornes des résistances R120 et R121, la sortie de mesure étant constituée par le courant d'annulation de flux.

Les capteurs magnétiques 32, 34 sont quant à eux alimentés en courant par des amplificateurs Z300 et Z301 qui fournissent un courant régulé en mesurant le courant traversant les capteurs via respectivement des résistances shunt R309 et R310 reliées à ces capteurs magnétiques, et l'équilibrage se fait en réglant un potentiomètre R300 reliant les entrées de ces deux amplificateurs. Ce potentiomètre peut être remplacé avantageusement par un potentiomètre numérique pour réaliser une calibration entièrement automatique de manière à ce que la pince de mesure indique un courant de 0mA.

Les entrefers 28, 30 ne pouvant mécaniquement être parfaitement identiques, les champs parasites ne vont pas se répartir de manière égale dans chaque entrefer et comme il a été mentionné précédemment, la compensation ne peut être parfaite en recourant aux seules fonctions précitées et il est alors nécessaire d'y associer une fonction de réglage des gains des capteurs magnétiques afin d'équilibrer parfaitement la mesure des deux capteurs, ce réglage de gain devant en outre pouvoir aussi être fait tout au long de la vie de la pince de mesure car celle-ci se dégrade au niveau de son blindage suite à des chocs par exemple ou au niveau des matériaux (matage) constituant les entrefers.

L'invention propose de s'affranchir du réglage traditionnel externe par une bobine de Helmotz et de générer un champ magnétique parasite dans les bobinages externes 40, 42 formant la bobine d'annulation de flux, un premier bobinage externe générant un champ magnétique tournant dans le sens horaire et le second dans le sens trigonométrique, de sorte à créer au niveau des deux capteurs à flux magnétique deux champs magnétiques orientés dans le même sens dans un repère cartésien (ou en opposition dans un repère tournant).

Pour ce faire, la boucle d'annulation de flux est ouverte en commutant les commutateurs Z201 et Z202 dans une position ouverte de réglage R. La résistance R200 permet d'imposer à une valeur nulle les courants différentiels circulant en opposition dans les bobinages externes. Les tensions de mode commun en sortie de l'amplificateur Z109 sont alors régulées à Vcc/2.

Ensuite, en pilotant de manière alternative à une fréquence de mode commun (FMC) les interrupteurs Q201 et Q202, un courant de mode commun peut être imposé dans les deux bobinages externes 40, 42 générant deux champs magnétiques orientés dans le même sens (dans un repère cartésien donc non tournant) au niveau des capteurs magnétiques.

Si les entrefers ne sont pas égaux, ou si les gains des capteurs sont différents, une tension apparait à la fréquence de mode commun aux bornes de la résistance R201 et il est alors nécessaire de modifier le réglage du potentiomètre R300 pour obtenir une tension nulle aux bornes de la résistance R201 et ainsi obtenir un équilibrage parfait.

A cette chaine d'acquisition et de mesure principale, il peut être ajouté une fonction supplémentaire de test permettant de vérifier la saturation des capteurs magnétiques, comme illustré à la figure 6 qui reprend les éléments déjà décrits en regard de la figure 5 précédente (les sorties des amplificateurs Z102 à Z105 étant toutefois connectées pour en additionner les signaux et non les soustraire comme dans la figure 5) et y ajoute des composants supplémentaires permettant la réalisation de cette fonction de test.

Pour ce faire, deux tensions de référence sont fixées avec les amplificateurs Z403 et Z404, des condensateurs C402 et C403 placés en sortie de ces amplificateurs permettant de faire une réserve d'énergie. Lorsqu'on souhaite faire un test pour vérifier que les capteurs magnétiques ne sont pas saturés, on passe à 1 le signal TEST. Les interrupteurs Q400 et Q401 conduisent et font circuler un courant égal à la tension de référence divisée par la valeur des résistances R417 (ou R418) dans les fils ou bobines de test 46, 48. Les tensions de référence ont préalablement été réglées grâce au potentiomètre R419 de manière à obtenir une tension en sortie des capteurs identiques. De cette manière, la soustraction des deux signaux vaut donc zéro et cette fonction de test n'affecte pas la chaine de mesure principale qui réagit comme explicité précédemment.

Ainsi, si la tension relevée aux bornes de la résistance R201 est positive, alors les capteurs magnétiques ne sont pas saturés. Si elle est de faible amplitude ou négative, alors les capteurs magnétiques sont saturés.

## Revendications

1. Pince (10) de mesure comportant une mâchoire fixe (12) et une mâchoire mobile (14), la mâchoire fixe comportant un premier noyau magnétique (20) et la mâchoire mobile comportant un second noyau magnétique (22), les premier et second noyaux magnétiques étant séparés par deux entrefers diamétralement opposés (28, 30) recevant chacun un capteur à flux magnétique (32, 34), et une bobine externe d'annulation de flux (40, 42), la pince de mesure étant **caractérisée en ce que** le premier noyau magnétique est entièrement entouré d'un premier blindage magnétique (24), **en ce que** le second noyau magnétique est entièrement entouré d'un second blindage magnétique (26), et **en ce que** la bobine externe d'annulation de flux (40,42) entoure l'un ou l'autre, ou les deux, des premier et second blindage magnétiques.

2. Pince de mesure selon la revendication 1, dans laquelle chacune des mâchoires fixe et mobile est formée d'un demi-tore de mesure (20, 22) assurant la concentration du champ magnétique interne entouré par un demi-blindage en matériau magnétique (24, 26) protégeant des champs magnétiques extérieurs, de préférence en Mu-métal.

3. Pince de mesure selon la revendication 2, dans laquelle le demi-tore de mesure (20) de la mâchoire fixe (12) comporte une fenêtre (44) à chaque extrémité pour les amenées de courant depuis une carte électronique (36) reliée par un câble de connexion (38) à une interface utilisateur de la pince de mesure.

4. Pince de mesure selon la revendication 2, dans laquelle la bobine externe d'annulation de flux est constituée de deux bobinages (40, 42) placés autour d'un seul des deux demi-blindages magnétiques, de préférence le demi-blindage (26) de la mâchoire mobile (14), et aptes à générer au niveau des deux capteurs à flux magnétique deux champs magnétiques en opposition dans un repère tournant.

5. Pince de mesure selon la revendication 2, dans laquelle la bobine externe d'annulation de flux est constituée de deux bobinages (40, 42) placés autour des deux demi-blindages magnétiques et aptes à générer au niveau des deux capteurs à flux magnétique deux champs magnétiques en opposition dans un repère tournant.

6. Pince de mesure selon l'une quelconque des revendications 1 à 5, dans lesquels les entrefers (28, 30) ont une largeur inférieure à 1mm et supérieure à la largeur du capteur à flux magnétique.

7. Pince de mesure selon l'une quelconque des revendications 1 à 5, dans laquelle le capteur à flux magnétique est un capteur AMR, la pince de mesure comprenant en outre une bobine de test (46, 48) disposée sous chacun des capteurs AMR (32, 34) pour générer un champ magnétique de valeur connue au niveau du capteur AMR et un circuit de test associé pour déterminer l'état de saturation des capteurs AMR.

8. Pince de mesure selon l'une quelconque des revendications 1 à 5, dans laquelle le capteur à flux magnétique est un capteur AMR se composant de quatre résistances ferromagnétiques à couche mince reliées à un pont de Wheatstone, une bobine de flip et un circuit de commande associé permettant d'inverser la polarité de la tension de sortie du pont en appliquant des impulsions de courant de réglage (set) et de réinitialisation (reset) à la bobine de flip.

9. Pince de mesure selon la revendication 8, dans laquelle les impulsions de set/reset sont pilotées à une fréquence de quelques kHz avec une durée de quelques centaines de nano secondes à quelques micros secondes.

10. Utilisation d'une pince de mesure selon l'une quelconque des revendications 1 à 9 à la mesure de courants de fuite AC et DC.

## Patentansprüche

1. Messzange (10), beinhaltend eine feste Backe (12) und eine bewegliche Backe (14), wobei die feste Backe einen ersten Magnetkern (20) beinhaltet und die bewegliche Backe einen zweiten Magnetkern (22) beinhaltet, wobei der erste und der zweite Magnetkern durch zwei diametral gegenüberliegende Luftspalte (28, 30) getrennt sind, die jeweils einen Magnetflusssensor (32, 34) aufnehmen, und eine äußere Flusskompensationsspule (40, 42), wobei die Messzange **dadurch gekennzeichnet ist, dass** der erste Magnetkern vollständig von einer ersten Magnetabschirmung (24) umgeben ist, dass der zweite Magnetkern vollständig von einer zweiten Magnetabschirmung (26) umgeben ist und dass die äußere Flusskompensationsspule (40, 42) eine oder beide von der ersten und der zweiten Magnetabschirmung umgibt.

2. Messzange nach Anspruch 1, wobei jede von der festen Backe und der beweglichen Backe aus einem Messhalbtorus (20, 22) gebildet ist, der die Konzentration des inneren Magnetfeldes sicherstellt, das von einer Halbabschirmung aus Magnetmaterial (24, 26) umgeben ist, die vor äußeren Magnetfeldern, bevorzugt aus Mu-Metall, schützt.

3. Messzange nach Anspruch 2, wobei der Messhalbtorus (20) der festen Backe (12) ein Fenster (44) an jedem Ende für die Stromversorgung von einer Elektronikplatine (36) beinhaltet, die über ein Verbindungskabel (38) mit einer Benutzerschnittstelle der Messzange verbunden ist.

4. Messzange nach Anspruch 2, wobei die äußere Flusskompensationsspule aus zwei Wicklungen (40, 42) besteht, die um eine der zwei Magnethalbabschirmungen, bevorzugt die Halbschirmung (26) der beweglichen Backe (14), platziert und in der Lage sind, auf Höhe der zwei Magnetflusssensoren zwei entgegengesetzte Magnetfelder in einem drehenden Bezugspunkt zu erzeugen.

5. Messzange nach Anspruch 2, wobei die äußere Flusskompensationsspule aus zwei Wicklungen (40, 42) besteht, die um die zwei Magnethalbabschirmungen platziert und in der Lage sind, auf Höhe der zwei Magnetflusssensoren zwei entgegengesetzte Magnetfelder in einem drehenden Bezugspunkt zu erzeugen.

6. Messzange nach einem der Ansprüche 1 bis 5, wobei die Luftspalte (28, 30) eine Breite von weniger als 1 mm und größer als die Breite des Magnetflusssensors aufweisen.

7. Messzange nach einem der Ansprüche 1 bis 5, wobei der Magnetflusssensor ein AMR-Sensor ist, die Messzange ferner eine Testspule (46, 48), die unter jedem der AMR-Sensoren (32, 34) angeordnet ist, um ein Magnetfeld von bekanntem Wert auf Höhe des AMR-Sensors zu erzeugen, und eine zugehörige Testschaltung zum Bestimmen des Sättigungszustands der AMR-Sensoren umfasst.

8. Messzange nach einem der Ansprüche 1 bis 5, wobei der Magnetflusssensor ein AMR-Sensor ist, der aus vier dünnschichtigen ferromagnetischen Widerständen besteht, die mit einer Wheatstone-Brücke, einer Kippspule und einer zugehörigen Steuerschaltung, die ermöglicht, die Polarität der Ausgangsspannung der Brücke durch Anlegen von Setzstromimpulsen (Set) und Rücksetzstromimpulsen (Reset) an die Kippspule umzukehren, verbunden sind.

9. Messzange nach Anspruch 8, wobei die Setz-/Rücksetzimpulse mit einer Frequenz von einigen kHz mit einer Dauer von einigen hundert Nanosekunden bis zu einigen Mikrosekunden gesteuert werden.

10. Verwendung einer Messzange nach einem der Ansprüche 1 bis 9 zum Messen von AC- und DC-Leckströmen.

## Claims

1. A measurement clamp (10) comprising a fixed jaw (12) and a moving jaw (14), wherein the fixed jaw comprises a first magnetic core (20) and the moving jaw comprises a second magnetic core (22), the first and second magnetic cores being separated by two diametrically opposite air gaps (28, 30) each receiving a magnetic flux sensor (32, 34), and an external flux-cancellation coil (40, 42), the measurement clamp being **characterized in that** the first magnetic core is entirely surrounded by a first magnetic shield (24), **in that** the second magnetic core is entirely surrounded by a second magnetic shield (26), an **in that** the external flux-cancellation coil (40, 42) surrounds one or the other, or both, of the first and second magnetic shields.

2. The measurement clamp according to claim 1, wherein each of the fixed and moving jaws is formed of a measurement half-torus (20, 22) ensuring the concentration of the internal magnetic field surrounded by a half-shield made of magnetic material (24, 26) protecting from external magnetic fields, preferably made of Mu-metal.

3. The measurement clamp according to claim 2, wherein the measurement half-torus (20) of the fixed jaw (12) comprises a window (44) at each end, for the current supplies from an electronic card (36) connected via a connection cable (38) to a user interface of the measurement clamp.

4. The measurement clamp according to claim 2, wherein the external flux-cancellation coil consists of two windings (40, 42) placed around one of the two magnetic half-shields, preferably the half-shield (26) of the moving jaw (14), and able to generate, at the two magnetic flux sensors, two opposing magnetic fields in a rotating reference frame.

5. The measurement clamp according to claim 2, wherein the external flux-cancellation coil consists of two windings (40, 42) placed around the two magnetic half-shields and able to generate, at the two magnetic flux sensors, two opposing magnetic fields in a rotating reference frame.

6. The measurement clamp according to any one of claims 1 to 5, wherein the air gaps (28, 30) have a width less than 1 mm and greater than the width of the magnetic flux sensor.

7. The measurement clamp according to any one of claims 1 to 5, wherein the magnetic flux sensor is an AMR sensor, the measurement clamp further comprising a test coil (46, 48) arranged under each of the AMR sensors (32, 34) in order to generate a magnetic field of known value at the AMR sensor and an associated test circuit for determining the saturation state of the AMR sensors.

8. The measurement clamp according to any one of claims 1 to 5, wherein the magnetic flux sensor is an AMR sensor consisting of four thin-film ferromagnetic resistors connected to a Wheatstone bridge, a flip coil and an associated control circuit enabling the polarity of the output voltage of the bridge to be reversed by applying current set (set) and reset (reset) pulses to the flip coil.

9. The measurement clamp according to claim 8, wherein the set/reset pulses are controlled at a frequency of several kHz with a duration of several hundred nanoseconds to several microseconds.

10. Use of a measurement clamp according to any one of claims 1 to 9 for measuring AC and DC leakage currents.
